# FASCICULE DE BREVET EUROPEEN

(11) **EP 1 468 960 B1**
(45) Date de publication et mention de la délivrance du brevet: **06.08.2008**
(21) Numéro de dépôt: 04300177.5
(22) Date de dépôt: 01.04.2004
(51) Int. Cl.: B81B 3/00, H03H 3/00, H03H 9/17, H03H 9/46, H03H 9/54, H01H 61/06, H03H 9/02, H03H 9/00, H03H 3/02, H03H 3/10

(54) **Microrésonateur accordable sur poutre isolante déformable par effet bilame**
Stimmbarer Mikroresonator auf isolierendem und mittels Bimetall - Effekt verbiegbarem Träger
Tunable bimetallic microresonator formed on an isolated flexible beam

(30) Priorité: 03.04.2003 FR 0304147
(43) Date de publication de la demande: 20.10.2004
(73) Titulaire: STMicroelectronics S.A., 92120 Montrouge (FR)
(72) Inventeur: Bouche, Guillaume, 38000 Grenoble (FR); Ancey, Pascal, 38420 Revel (FR); Caruyer, Grégory, 38570 Goncelin (FR)
(74) Mandataire: de Beaumont, Michel

(56) Documents cités:
- EP-A- 1 180 494
- DE-A- 10 124 349
- US-A- 3 916 348
- US-A- 5 969 465
- US-B1- 6 316 796
- TANG W C: "Microengineered Actuators: A Review" 4031166 ELECTRO INTERNATIONAL. CONFERENCE RECORD, NEW YORK, NY, USA, 16-18 APRIL 1991, 16 avril 1991 (1991-04-16), pages 104-109, XP010305313

## Description

La présente invention concerne le domaine des micro-résonateurs piézoélectriques.

Un microrésonateur piézoélectrique comprend de façon classique une couche piézoélectrique prise en sandwich entre deux électrodes conductrices. Un tel microrésonateur, décrit dans le document EP-A-1180494, est susceptible de rentrer en résonance quand le signal appliqué entre ses électrodes est à une fréquence déterminée.

En dehors de toute influence extérieure, la fréquence de résonance d'un microrésonateur est fixée lors de sa fabrication en fonction notamment de l'épaisseur et de la nature de la couche piézoélectrique. Or, pour de nombreux circuits tels que des filtres analogiques réglables, il est souhaitable de pouvoir faire varier la fréquence de résonance des micro-résonateurs.

Un objet de la présente invention est de prévoir un microrésonateur accordable.

Pour atteindre cet objet, la présente invention prévoit un dispositif comprenant un résonateur formé d'une couche piézoélectrique en sandwich entre deux électrodes métalliques, le résonateur étant posé sur une poutre en suspension, le dispositif comprenant des moyens pour déformer ladite poutre par effet bilame.

Selon une variante du dispositif de la présente invention, les moyens pour déformer la poutre comprennent des éléments chauffants et un ou plusieurs blocs en contact avec la poutre, les blocs étant constitués d'un matériau ayant un coefficient de dilation thermique différent de celui de la poutre.

Selon une variante du dispositif susmentionné, les éléments chauffants sont placés dans la poutre.

Selon une variante du dispositif de la présente invention, des électrodes sont placées dans la poutre en regard d'autres électrodes externes à la poutre, les électrodes étant reliées à une source de tension apte à polariser les électrodes pour maintenir la déformation de la poutre.

Selon une variante du dispositif susmentionné, la poutre est placée au-dessus d'une cavité formée dans un substrat, les électrodes externes étant placées dans la cavité.

La présente invention prévoit aussi un circuit intégré comprenant un résonateur tel que celui décrit ci-dessus.

Cet objet, ces caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1 est une vue en coupe d'un mode de réalisation du dispositif de la présente invention dans un état de repos ;
la figure 2 est une vue en coupe du dispositif de la présente invention dans un état "déformé" ; et
la figure 3 est une vue de dessus du dispositif de la présente invention.

Comme cela est habituel dans la représentation des microcomposants, les diverses figures ne sont pas tracées à l'échelle.

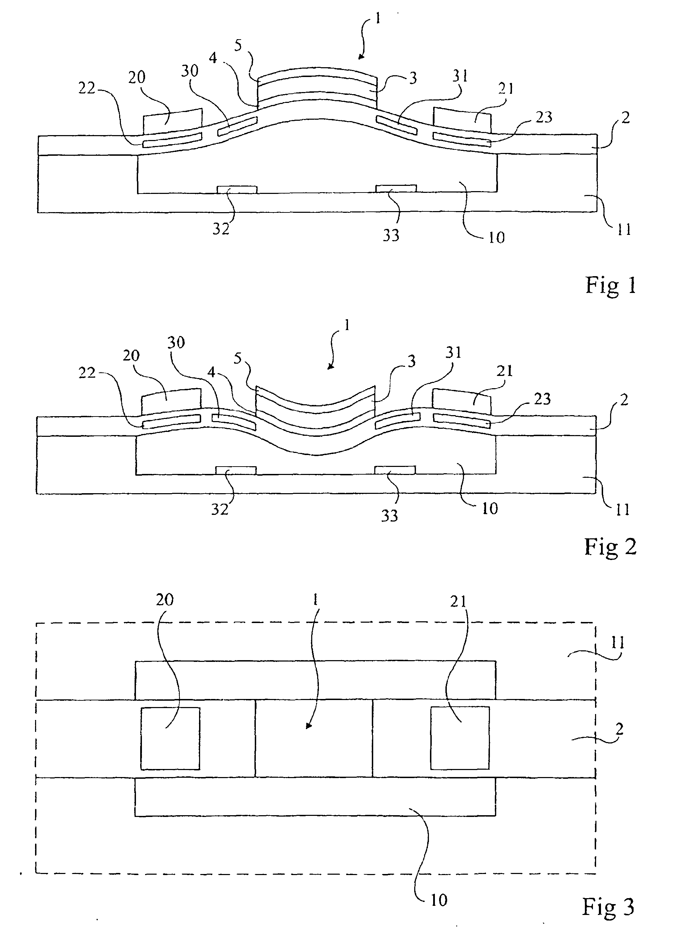

Le dispositif de la présente invention, représenté en figures 1 et 2, comprend un résonateur 1 posé sur une poutre 2 en suspension sur ses deux extrémités. Le résonateur 1 est constitué d'un empilement de couches minces et comprend une couche piézoélectrique 3 en sandwich entre deux électrodes conductrices 4 et 5. La couche piézoélectrique 3 est par exemple constituée de nitrure d'aluminium AIN et les électrodes sont par exemple constituées d'aluminium, de molybdène ou de platine. La poutre 2 est une fine bande d'un matériau isolant tel que du nitrure de silicium (SiN). La poutre 2 est en suspension au-dessus d'une cavité 10 formée dans un substrat 11. Les extrémités de la poutre 2 sont posées sur le substrat 11 d'un côté et de l'autre de la cavité 10.

Comme l'illustre la figure 3, en vue de dessus, les bords latéraux de la poutre 2 sont écartés des bords de la cavité 10.

Le substrat 11 peut être constitué de tout type de matériau. Dans le cas où le dispositif de la présente invention fait partie d'un circuit intégré, le substrat 11 pourra être la couche de passivation recouvrant le réseau d'interconnexions du circuit ou être la couche isolante séparant le dernier et l'avant dernier niveau d'interconnexions du circuit. Dans le cas où le dispositif est un composant discret, le substrat 11 peut être une tranche semiconductrice de silicium ou être une couche isolante, par exemple de l'oxyde de silicium, posée sur une tranche de support, par exemple en silicium.

Selon un aspect de la présente invention, le dispositif comprend des moyens pour déformer la poutre 2 par effet bilame. Le résonateur 1 étant posé sur la poutre du résonateur, une déformation de la poutre 2 entraîne une déformation du résonateur. Or la fréquence de résonance varie en fonction de la déformation du résonateur 1.

Dans l'exemple du dispositif représenté en figures 1 et 2, des blocs métalliques 20 et 21 sont posés sur la poutre 2. Le résonateur 1 est placé au centre de la portion de la poutre 2 située au-dessus de la cavité 10. Les blocs 20 et 21 sont placés de part et d'autre du résonateur 1. Des résistances chauffantes 22 et 23 sont placées sous les blocs 20 et 21 à l'intérieur de la poutre 2. Les résistances chauffantes 22 et 23 sont par exemple constituées d'une couche de nitrure de titane TiN et sont alimentées par l'intermédiaire de connexions non représentées.

Afin de diffuser au mieux la chaleur produite par les résistances chauffantes dans la poutre 2 vers les blocs métalliques 20 et 21, les résistances chauffantes ont de préférence en vue de dessus une largeur proche de la largeur de la poutre et s'étendent dans toute la zone de la poutre située sous les blocs 20 et 21. De plus, la chaleur produite par les résistances chauffantes 22 et 23 étant proportionnelle à leur résistance, on pourra réduire leur épaisseur au maximum.

Pour passer de l'état de repos à l'état déformé, tel qu'illustré respectivement en figures 1 et 2, un circuit d'activation, non représenté, fait passer du courant dans les résistances chauffantes 22 et 23, ce qui a pour effet de chauffer les blocs 20 et 21 et la poutre 2. L'aluminium des blocs 20 et 21 ayant un coefficient de dilatation supérieur au nitrure de silicium de la poutre 2, les blocs 20 et 21 s'allongent davantage que la poutre 2. En conséquence, les extrémités de la poutre se bombent légèrement vers le haut et la partie centrale de la poutre se creuse vers le bas. Durant la déformation de la poutre 2, le microrésonateur 1 posé sur la poutre 2 se tord progressivement, ses extrémités se relevant.

Afin de bénéficier d'une grande latitude de déformation de la poutre 2 et donc du résonateur 1, la poutre 2 pourra avoir à l'état de repos une forme légèrement bombée vers le haut comme cela est représenté en figure 1.

De façon générale, les blocs 20 et 21 posés sur la poutre 2 doivent être constitués d'un matériau ayant un coefficient de dilatation thermique différent de celui de la poutre 2 afin que l'ensemble des blocs et de la poutre se tord quand la température augmente. Dans le cas où les blocs métalliques 20 et 21 ont un coefficient de dilatation thermique plus faible que celui de la poutre 2, on pourra prévoir de placer les blocs sous la poutre 2.

La fréquence de résonance du résonateur variant en fonction de sa déformation, le circuit d'activation pourra régler la fréquence de résonance du résonateur en faisant passer un courant de commande plus ou moins fort dans les résistances chauffantes 22 et 23 afin de déformer plus ou moins le résonateur 1. De plus, le circuit d'activation pourra comprendre un dispositif d'asservissement capable de déterminer la fréquence de résonance actuelle du résonateur et de modifier l'intensité du courant de commande afin d'ajuster si nécessaire la fréquence de résonance pour qu'elle ait exactement une valeur souhaitée.

Afin de maintenir la déformation de la poutre, et donc du résonateur, sans consommer un courant trop élevé dans les résistances chauffantes 22 et 23, la présente invention prévoit, à titre d'option, de placer des électrodes "internes" 30 et 31 dans la poutre 2, et de placer des électrodes "externes" 32 et 33 au fond de la cavité 10 en regard des électrodes internes 30 et 31. Une fois la poutre déformée sous l'action de l'effet bilame, il est possible de maintenir la déformation par attraction électrostatique en appliquant une tension entre les électrodes internes 30/31 et les électrodes externes 32/33, ces diverses électrodes étant associés à des moyens de connexion non représentés.

Les électrodes internes 30 et 31 sont par exemple constituées d'une fine couche de nitrure de titane (TiN) comme les éléments chauffants 22 et 23. Les électrodes externes 32 et 33 peuvent être en aluminium, en cuivre ou encore en or qui présente l'avantage de ne pas s'oxyder dans l'air. Les électrodes externes 32 et 33 peuvent être des portions du dernier niveau d'interconnexions d'un circuit intégré.

A titre d'exemple non-limitatif, les dimensions des différents éléments du dispositif de la présente invention sont les suivantes :
- épaisseur des électrodes du résonateur : 0,1 µm
- épaisseur de la couche piézoélectrique du résonateur : 2 µm
- largeur/longueur du résonateur : 150*150 µm
- épaisseur de la poutre : 2 µm
- largeur/longueur de la poutre : 200*500 µm
- épaisseur des blocs en aluminium : 2 µm
- épaisseur des résistances chauffantes de titane/aluminium : 0,5 µm
- largeur/longueur des résistances chauffantes : 200*200 µm²
- épaisseur des électrodes internes en nitrure de titane/aluminium : 0,5 µm
- épaisseur des électrodes externes en or : 1 µm
- profondeur de la cavité : 10 µm

Avec un tel dispositif, il est possible par exemple de faire varier la fréquence de résonance du résonateur de quelques MHz (pour un résonateur centré à 2 GHz).

Un dispositif selon la présente invention comprend des lignes d'accès, non représentées, aux électrodes 4 et 5 du microrésonateur 1. De telles lignes d'accès sont par exemple placées sur la poutre 2. Afin de relier l'électrode supérieure 5 du résonateur à une ligne d'accès située sur la poutre, le dispositif comprend par exemple une fine bande piézoélectrique posée sur la poutre 2 et juxtaposée à la couche piézoélectrique 3. L'électrode supérieure se prolonge par une fine bande conductrice placée au-dessus de la fine bande piézoélectrique. Un via conducteur isolé traversant la fine bande piézoélectrique permet de relier la fine bande conductrice à une ligne d'accès placée sur la poutre.

De même, le dispositif comprend des lignes d'accès aux résistances chauffantes 22 et 23 et aux électrodes internes 30 et 31. De telles lignes d'accès peuvent être des zones métalliques placées dans, sur ou sous la poutre 2.

Les électrodes du résonateur, les résistances chauffantes 22 et 23, les électrodes internes 30 et 31, et les électrodes externes 32 et 33, peuvent être reliées à des plots de connexion ou à des éléments d'un circuit intégré.

Dans le cas où le dispositif est un composant discret, les plots de connexion peuvent être formés sur la face arrière du substrat 11, la face avant étant celle où est formée le résonateur.

Que le dispositif soit un composant discret ou qu'il fasse partie d'un circuit intégré, les divers éléments susmentionnés peuvent être reliés à un réseau de connexions placé sous le substrat ou à un plot de connexion en face arrière par l'intermédiaire de vias formés dans le substrat et éventuellement de vias formés dans la poutre dans le cas où les éléments sont placés sur la poutre.

Dans le cas où le dispositif de la présente invention fait partie d'un circuit intégré, les électrodes externes 32 et 33 peuvent être des portions du dernier niveau d'inter-connexions. Les électrodes externes sont alors reliées directement au réseau d'interconnexions du circuit.

Bien entendu, la présente invention est susceptible de diverses variantes et modifications qui apparaîtront à l'homme de l'art. En particulier, l'homme de l'art saura imaginer d'autres dispositifs de déformation de la poutre par effet bilame. On pourra placer des éléments dilatables ayant un coefficient de dilatation différent de celui de la poutre, autour, sous ou/et sur la poutre. Les éléments dilatables pourront éventuellement être séparés de la poutre par une couche diélectrique. Les résistances chauffantes pourront être placées sur la poutre ou sur les éléments dilatables.

## Revendications

1. Dispositif comprenant un résonateur (1) formé d'une couche piézoélectrique (3) en sandwich entre deux électrodes métalliques (4, 5), le résonateur étant posé sur une poutre en suspension, **caractérisé en ce que** le dispositif comprend des moyens (20, 21, 22, 23) pour déformer ladite poutre (2) par effet bilame.

2. Dispositif selon la revendication 1, dans lequel les moyens pour déformer la poutre (2) comprennent des éléments chauffants (22, 23) et un ou plusieurs blocs (20,21) en contact avec la poutre, les blocs étant constitués d'un matériau ayant un coefficient de dilation thermique différent de celui de la poutre.

3. Dispositif selon la revendication 2, dans lequel les éléments chauffants (22, 23) sont placés dans la poutre (2).

4. Dispositif selon la revendication 1, dans lequel des électrodes (30, 31) sont placées dans la poutre (2) en regard d'autres électrodes (32, 33) externes à la poutre, les électrodes étant reliées à une source de tension apte à polariser les électrodes pour maintenir la déformation de la poutre.

5. Dispositif selon la revendication 4, dans lequel la poutre (2) est placée au-dessus d'une cavité (11) formée dans un substrat (10), les électrodes externes (32,33) étant placées dans la cavité.

6. Circuit intégré comprenant un dispositif selon la revendication 1.

## Claims

1. A device comprising a resonator (1) formed of a piezoelectric layer (3) sandwiched between two metal electrodes (4, 5), the resonator being laid on a suspended beam, **characterized in that** the device comprises means (20, 21, 22, 23) for deforming said beam (2) by bimetal effect.

2. The device of claim 1, wherein the means for deforming the beam (2) comprise heating elements (22, 23) and one or several blocks (20, 21) in contact with the beam, the blocks being formed of a material having a thermal expansion coefficient different from that of the beam.

3. The device of claim 2, wherein the heating elements (22, 23) are placed within the beam (2).

4. The device of claim 1, wherein electrodes (30, 31) are placed in the beam (2) opposite to other electrodes (32, 33) external to the beam, the electrodes being connected to a voltage source capable of biasing the electrodes to maintain the beam deformation.

5. The device of claim 4, wherein the beam (2) is placed above a cavity (11) formed in a substrate (10), the external electrodes (32, 33) being placed in the cavity.

6. An integrated circuit comprising the device of claim 1.

## Patentansprüche

1. Eine Vorrichtung, die einen Resonator (1) aufweist, der aus einer piezo-elektrischen Schicht (3) aufgebaut ist, die sandwichartig zwischen zwei Metallelektroden (4, 5) aufgenommen ist, wobei der Resonator auf einem aufgehängten Träger gelegt ist, **dadurch gekennzeichnet, dass** die Vorrichtung Mittel (20, 21, 22, 23) zum Verformen des Trägers (2) durch einen Bimetalleffekt aufweist.

2. Vorrichtung nach Anspruch 1, wobei die Mittel zum Verformen des Trägers (2) Heizelemente (22, 23) aufweisen und einen oder mehrere Blöcke (20, 21), die in Kontakt mit dem Träger stehen, wobei die Blöcke aus einem Material mit einem thermischen Ausdehnungskoeffizienten aufgebaut sind, die sich von dem des Trägers unterscheiden.

3. Vorrichtung nach Anspruch 2, wobei die Heizelemente (22, 23) innerhalb des Trägers (2) platziert sind.

4. Vorrichtung nach Anspruch 1, wobei Elektroden (30, 31) in dem Träger (2) platziert sind, und zwar entgegengesetzt zu den anderen Elektroden (32, 33) außerhalb des Trägers, wobei die Elektroden mit einer Spannungsquelle verbunden sind, die geeignet ist die Elektroden vorzuspannen, um die Trägerverformung beizubehalten.

5. Vorrichtung nach Anspruch 4, wobei der Träger (2) oberhalb eines Hohlraums (11) platziert ist, der in einem Substrat (10) ausgebildet ist, wobei die externen Elektroden (32, 33) in dem Hohlraum platziert sind.

6. Eine integrierte Schaltung, die eine Vorrichtung nach Anspruch 1 aufweist.
